Europäisches Patentamt

European Patent Office

Office européen des brevets

(19)

(11) Numéro de publication : **0 653 504 A1**

# (12) DEMANDE DE BREVET EUROPEEN

(21) Numéro de dépôt : **94402562.6**

(22) Date de dépôt : **14.11.94**

(51) Int. Cl.⁶ : **C30B 15/34,** C30B 15/00

(30) Priorité : **16.11.93 FR 9313648**

(43) Date de publication de la demande :
**17.05.95 Bulletin 95/20**

(84) Etats contractants désignés :
**DE GB IT**

(71) Demandeur : **COMMISSARIAT A L'ENERGIE ATOMIQUE**
**31-33, rue de la Fédération**
**F-75015 Paris (FR)**

(72) Inventeur : **Duffar, Thierry**
**21, Grande Rue**
**F-38700 La Tronche (FR)**

Inventeur : **Favier, Jean-Jacques**
**12, Avenue Alsace Lorraine**
**F-38000 Grenoble (FR)**
Inventeur : **Nabot, Jean-Philippe**
**Parc de Rocheplaine - Bois Fleuri C5**
**F-38120 Saint-Egreve (FR)**
Inventeur : **Servage, Raymond**
**Belmont**
**F-38410 Uriage (FR)**
Inventeur : **Tatartchenko, Vitali**
**6, rue Billerey**
**F-38000 Grenoble (FR)**

(74) Mandataire : **Dubois-Chabert, Guy et al**
**c/o BREVATOME**
**25, rue de Ponthieu**
**F-75008 Paris (FR)**

(54) **Procédé de fabrication de pièces en matériau polycristallin ou monocristallin par croissance à partir d'un bain fondu.**

(57)    L'invention concerne un procédé de fabrication de pièces en matériau polycristallin ou monocristallin par croissance à partir d'un bain fondu.

Selon ce procédé, on part d'un bain de matériau fondu 2 et l'on tire le matériau fondu selon la direction D1 à travers la filière 3 pour le solidifier sur le germe 9. Pour obtenir des formes plus ou moins complexes, on soumet de plus le germe et/ou la filière à au moins un mouvement de translation, par exemple selon $D_2$ ou $D_3$, dans un plan perpendiculaire à la direction $D_1$ de tirage. On peut de plus soumettre simultanément le germe à un mouvement de rotation sur lui-même.

La mise en oeuvre de ces mouvements et un réglage approprié des vitesses de déplacement permet d'obtenir n'importe quelle forme voulue.

FIG. 2

EP 0 653 504 A1

La présente invention a pour objet un procédé de fabrication de pièces en matériaux polycristallins ou monocristallins par croissance cristalline à partir d'un bain liquide dudit matériau.

De façon plus précise, elle concerne les procédés de croissance cristalline par tirage du matériau fondu au travers d'une filière et cristallisation du matériau fondu sortant de la filière sur un germe.

Des procédés de fabrication de pièces polycristallines ou monocristallines de ce type sont décrits en particulier dans les documents, US-A- 3 868 228, US-A-3 915 662, US-A-4 430 305 et WO-92/03204. Avec ces procédés qui sont connus aux Etats-Unis sous le nom de procédé EFG, on peut obtenir des monocristaux de divers produits, en particulier de saphir blanc ou de semi-conducteurs comme Si ou Ge, en solidifiant un liquide à partir d'un germe. La forme extérieure du solide est déterminée par la forme du ménisque liquide juste avant solidification qui dépend en particulier de la filière utilisée. Ainsi, une filière de section carrée donnera un ménisque de section carrée ainsi que le solide correspondant. On obtiendra un solide en forme de tube si le ménisque liquide a la forme d'un anneau. En fait, la filière a deux fonctions : d'une part, donner au ménisque liquide la forme voulue et, d'autre part, alimenter en liquide la zone de solidification.

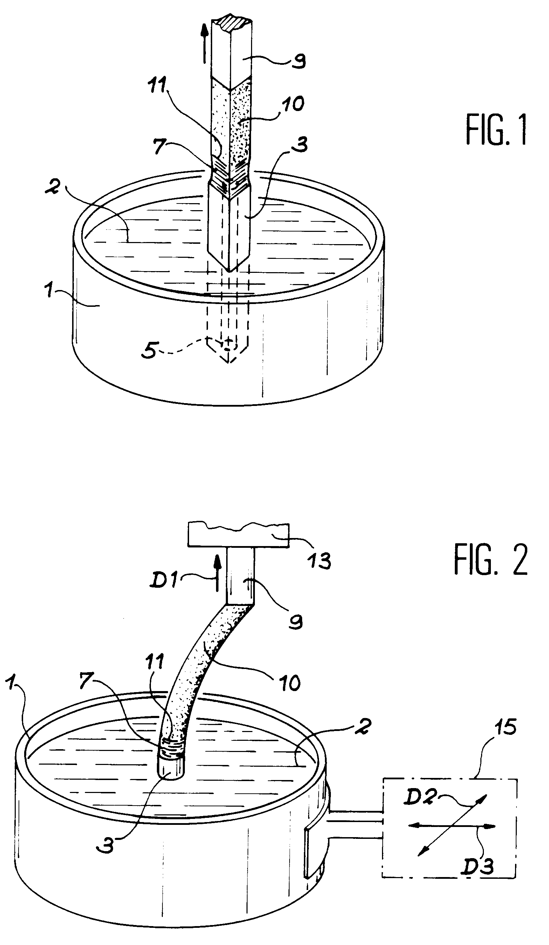

Sur la figure 1, on a représenté de façon schématique l'obtention de pièces solides par ce procédé. Dans un tel procédé, l'alimentation se fait en général à partir d'un creuset 1 contenant le liquide 2 à solidifier, par l'intermédiaire d'une filière 3 qui comporte au moins un perçage interne 5 dans lequel le liquide provenant du creuset peut circuler soit par remontée capillaire, dans le cas où le liquide mouille le matériau de la filière, soit sous l'effet d'une différence de pression entre la surface du liquide 2 dans le creuset et la sortie de la filière. A la sortie de la filière 3, on obtient un ménisque liquide 7 et la solidification du liquide est amorcée sur un germe monocristallin 9 et se poursuit par tirage de ce germe et du solide formé 10 vers le haut dans le sens de la flèche. La forme précise du solide obtenu dépend de la distance entre l'interface 11 de solidification et la sortie de la filière 3 mais reste toujours proche de cette dernière. Le positionnement de cet interface peut être règlé en contrôlant l'apport de calories au creuset 1.

Avec ce procédé, pour obtenir des pièces ayant des formes plus compliquées, on peut utiliser des filières de forme adaptée éventuellement modifiable au cours du tirage comme il est décrit dans US-A- 3 915 662 et US-A- 3 868 228. On peut éventuellement soumettre de plus le germe sur lequel se solidifie la pièce, à un mouvement de rotation sur lui-même ou à un mouvement de rotation autour d'un axe excentré par rapport au germe comme il est décrit dans le document WO-A-92/03240 et par Borodin et al dans Journal of Crystal Growth, 104, 1990, p-69-76.

Cependant, les techniques décrites ci-dessus permettent d'obtenir des pièces ayant seulement la forme de tubes ou de disques et ne conviennent donc pas lorsqu'on veut préparer des pièces de forme complexe, par exemple dont la section droite varie sur la hauteur de la pièce.

Or, l'industrie moderne utilise de plus en plus des matériaux de forme complexe et, dans le cas de matériaux très coûteux ou très difficiles à usiner, il est plus économique de les obtenir directement sous la forme voulue plutôt que de les usiner dans une pièce massive. Cela est encore plus vrai dans le cas des monocristaux qui sont par nature très onéreux et présentent souvent des propriétés mécaniques exceptionnelles.

La présente invention a précisément pour objet un procédé de fabrication de pièces polycristallines ou monocristallines, notamment de forme complexe, par tirage à partir d'un bain liquide du matériau constituant la pièce.

Selon l'invention, le procédé de fabrication d'une pièce en matériau polycristallin ou monocristallin consiste à former la pièce à partir d'un bain dudit matériau fondu par tirage au travers d'une filière et cristallisation du matériau fondu sortant de la filière sur un germe, et il se caractérise en ce que, au cours du tirage, on soumet de plus la filière et/ou le germe a au moins un mouvement de translation dans un plan perpendiculaire à la direction de tirage.

Généralement, le tirage s'effectue dans le sens vertical et le(s) mouvement(s) de translation du germe et/ou de la filière sont effectués dans des plans horizontaux.

Avec ce procédé, on combine donc une translation verticale du germe et de la pièce en cours de réalisation avec des translations horizontales du ménisque liquide par rapport à la pièce dans deux ou trois directions et ces directions peuvent être modifiées au cours du tirage de façon à obtenir des formes complexes. En règlant judicieusement les vitesses de déplacement selon les deux ou trois directions en fonction du temps, on peut obtenir toutes les formes de solide voulues. On précise qu'une ou plusieurs vitesses de déplacement peuvent être nulles à certains instants. Ainsi, avec ce procédé, la forme donnée au ménisque par la filière peut ne représenter que partiellement la forme de la pièce finie. On peut donc combiner, si nécessaire, l'emploi de filières de forme complexe avec les mouvements de translation de la filière et/ou du germe pour obtenir des pièces de forme très complexe.

Selon une variante de mise en oeuvre du procédé de l'invention, on soumet de plus le germe à un mouvement de rotation autour d'un axe centré sur le germe, ce qui permet d'obtenir des formes axisymétriques difficiles à réaliser sans cette rotation.

Pour la mise en oeuvre du procédé de l'invention, le contrôle des mouvements peut se faire manuellement, mais de préférence on réalise un pilotage de ces mouvements par un ordinateur programmé de manière à régler les vitesses de déplacement en fonction du temps afin d'obtenir la forme voulue.

Ce procédé est donc très avantageux, car il permet l'obtention de toutes les formes possibles de solide en ne nécessitant pas ou que très peu d'usinage après l'élaboration de la pièce. On peut ainsi bénéficier d'un gain de temps, de matière et d'une réduction considérable des frais d'usinage.

On peut également obtenir des formes impossibles à réaliser par usinage, en particulier des formes creuses fermées, et des formes pleines dont la section droite peut varier brutalement et présenter des parties rentrantes.

Avec les procédés de l'art antérieur, on pouvait parfois obtenir des formes complexes, mais dans ce cas, il était nécessaire d'utiliser des filières extrêmement complexes et onéreuses, alors qu'avec le procédé de l'invention, on peut obtenir le même résultat avec une filière beaucoup plus simple, par exemple un tube de section circulaire ou carrée.

D'autres caractéristiques et avantages de l'invention apparaîtront mieux à la lecture de la description qui suit, donnée bien entendu à titre illustratif et non limitatif, en référence aux dessins annexés sur lesquels :

- la figure 1 déjà décrite illustre schématiquement le procédé classique de tirage de matériaux polycristallins ou monocristallins au travers d'une filière, conformément à l'art antérieur,
- la figure 2 illustre schématiquement le procédé de l'invention,
- la figure 3 représente un mode de mise en oeuvre du procédé de l'invention pour l'obtention d'une plaque,
- la figure 4 représente schématiquement un autre mode de mise en oeuvre du procédé de l'invention pour l'obtention d'une cuve à fond plat,
- la figure 5 représente un autre mode de mise en oeuvre du procédé de l'invention pour l'obtention d'une baguette courbe de section circulaire, et
- la figure 6 représente un autre mode de mise en oeuvre du procédé de l'invention pour l'obtention d'un ellipsoïde de révolution.

Sur la figure 2, on a repris les mêmes références que celles de la figure 1 pour désigner les composants communs aux deux procédés. Ainsi, sur cette figure, le matériau liquide 2 placé dans le creuset 1 remonte par la filière 3 pour former un ménisque 7 et se solidifier sur le germe 9 qui est entraîné dans le sens vertical $D_1$ par le système de tirage, l'interface solide-liquide 11 étant positionné au-dessus de la filière.

Conformément à l'invention, l'ensemble creuset 1-filière 3 peut être déplacé dans le plan horizontal pour effectuer des mouvements de translation dans différentes directions, par exemple $D_2$ et $D_3$, au moyen d'un système de déplacement 15 associé au creuset.

Bien entendu, conformément à l'invention, on pourrait associer le système de déplacement 15 dans un plan horizontal, non pas au creuset 1, mais au germe 9 afin de faire décrire à ce dernier le mouvement voulu pour obtenir la forme désirée. On peut aussi obtenir le mouvement relatif entre le germe et le ménisque de cristallisation par déplacement simultané de la filière et du germe dans les directions voulues. Dans tous les cas, la filière est située en face du germe au début du tirage.

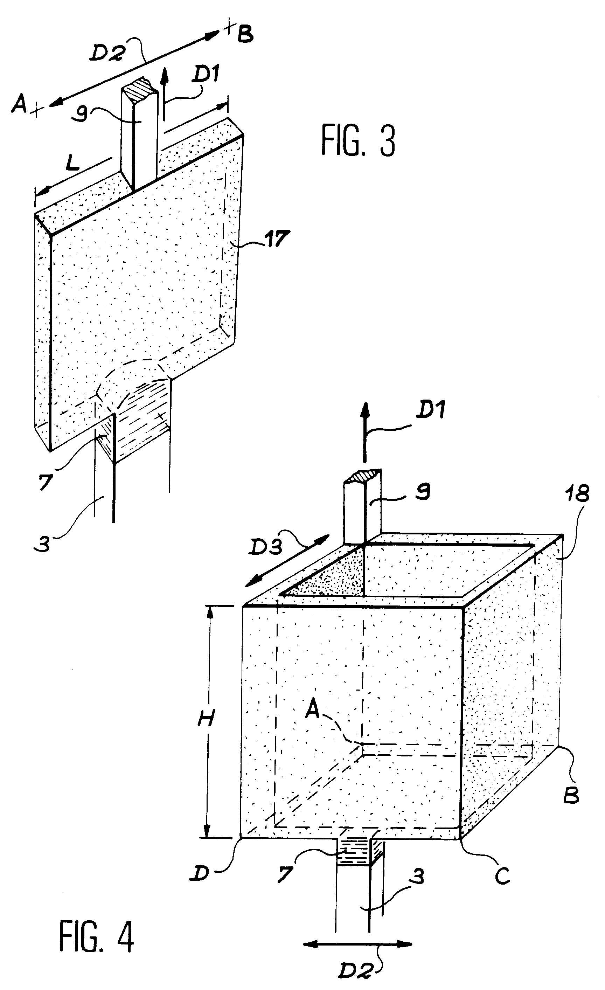

Sur la figure 3, on a représenté un mode de mise en oeuvre du procédé de l'invention en vue d'obtenir une pièce en forme de plaque, qui consiste à soumettre la filière et/ou le germe, pendant toute la durée du tirage, à un mouvement de va et vient entre deux positions extrêmes déterminant la largeur de la plaque.

Sur la figure 3, on a uniquement représenté l'extrémité de la filière 3, le ménisque liquide 7 sortant de la filière 3, le germe 9, et la pièce 17 formée. Pour obtenir cette pièce, on déplace le germe 9 à une vitesse constante vers le haut (direction $D_1$) tout en lui imposant un mouvement de va et vient dans la direction $D_2$ entre les deux positions extrêmes A et B, qui déterminent la largeur L de la plaque à préparer.

Comme précédemment, le mouvement de va et vient peut être obtenu en déplaçant la filière plutôt que le germe ou par un mouvement combiné du germe et de la filière.

Dans ce mode de mise en oeuvre du procédé de l'invention, pour obtenir de bonnes propriétés cristallines et dimensionnelles, il est nécessaire de refondre partiellement la partie de la pièce précédemment solidifiée lorsque, après un aller-retour, elle se trouve à nouveau en contact avec le ménisque 7. Dans ce but, on règle de façon optimale la vitesse de tirage verticale et la vitesse du mouvement de va et vient horizontal pour obtenir cette refusion partielle.

Sur la figure 4, on a représenté un mode de mise en oeuvre du procédé en vue d'obtenir une cuve 18 à section carrée ou rectangulaire et à fond plat.

Pour obtenir cette forme, le procédé comprend :
- une première phase dans laquelle on forme les parois de la cuve en soumettant à des mouvements de translation dans une première direction puis dans une deuxième direction, le germe ou la filière de façon à décrire la section droite de la pièce à obtenir, et
- une deuxième phase dans laquelle on forme le fond de la cuve en soumettant la filière ou le germe à un mouvement de va et vient entre deux positions telles que la distance entre ces deux positions corrresponde à la longueur (ou à la largeur) de la section de la cuve, en déplaçant la filière ou le germe entre deux mouvements de va et vient dans un sens perpendiculaire au tracé du mouvement précédent d'une distance légèrement inférieure à la largeur de la filière, et en renouvelant ces opérations autant de fois qu'il est nécessaire pour couvrir le fond.

Dans la première phase, on effectue les étapes successives suivantes tout en déplaçant le germe verticalement selon la direction $D_1$,

a) le germe 9 et la filière 3 étant dans des positions qui correspondent au point A, on déplace la filière 3 dans la direction $D_2$ depuis la position A jusqu'à la position B,

b) on déplace ensuite la filière dans la direction $D_3$ de la position B à la position C,

c) on déplace ensuite la filière dans la direction $D_2$ de la position C à la position D,

d) on déplace la filière de D en A, et on renouvelle les opérations a), b), c) et d) autant de fois qu'il est nécessaire pour obtenir la hauteur voulue H de la cuve.

Dans la deuxième phase, lorsque la hauteur H est obtenue, on réalise le fond de la cuve par des mouvements de va et vient de la filière dans la direction $D_3$ en déplaçant la filière après chaque aller-retour dans le sens $D_2$ d'une distance inférieure à la largeur du ménisque. L'épaisseur du fond peut être augmentée en recommençant ces opérations finales autant de fois qu'il est nécessaire.

On peut aussi obtenir une cuve à section carrée ou rectangulaire à fond plat en effectuant des mouvements successifs du germe suivant D3 et de la filière suivant D2. Dans ce cas, le processus comprend alors les étapes suivantes en partant de la situation où le germe et la filière sont en A :

1) la filière se déplace de A en B, on fabrique le côté AB,

2) le germe se déplace de A en D, on fabrique le côté BC,

3) la filière revient en A, on fabrique le côté CD,

4) le germe revient en A, on fabrique le côté DA, et on recommence.

Pour le fond, on effectue un va et vient du germe suivant AD avec un déplacement lent de la filière suivant AB.

En généralisant le principe décrit ci-dessus, on peut obtenir n'importe quelle forme pleine de dimensions nettement supérieures à celles du ménisque. Le dispositif pour obtenir ces déplacements relatifs nécessite généralement l'usage de deux moteurs et éventuellement de bielles solidaires de ces moteurs.

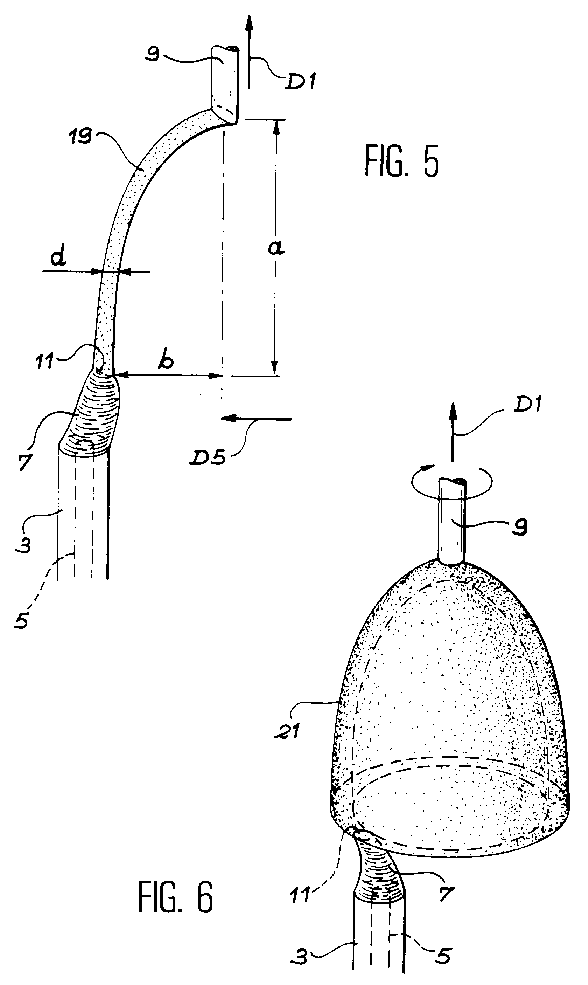

Sur la figure 5, on a représenté l'obtention d'une baguette courbe 19 de section circulaire utilisant les mouvements combinés de tirage vertical et de translation dans le sens horizontal du germe 9 et de la pièce en cours de solidification.

Sur cette figure, on voit la filière 3 percée d'un canal central 5 par lequel pénètre le liquide pour former à la sortie de la filière un ménisque 7 avec une interface solide-liquide 11 de la pièce en cours de solidification 19. Dans ce cas, on déplace comme précédemment le germe 9 dans le sens vertical $D_1$ en faisant décrire à la filière 3 un mouvement de translation horizontale selon la direction D5 à une vitesse appropriée. Le diamètre de la filière est adapté de manière à obtenir le diamètre voulu $d$ de la baguette courbe 19, lequel dépend également de la position de l'interface 11 au-dessus de la filière 3. Pour obtenir une baguette ayant la forme d'une branche d'ellipse de demi-axes $a$ et $b$, le mouvement de translation horizontale de la filière est effectué entre une première position dans laquelle le germe et la filière sont alignés et une deuxième position dans laquelle le germe est à la distance $b$ de la filière, et on règle la vitesse de tirage vertical $v_t$ et la vitesse de translation horizontale $v_h$ de la filière en fonction du temps t, de façon à avoir :

$$v_t = (\pi a/2\tau) \sin (\pi t/2\tau) \text{ et } v_h = (\pi b/2\tau) \cos(\pi t/2\tau)$$

avec $\tau$ représentant la durée de tirage et $a$ et $b$ représentant respectivement les demi-axes de l'ellipse.

Sur la figure 6, on a représenté l'obtention d'un ellipsoïde 21 de révolution obtenu comme dans le cas de la figure 5, mais en imprimant de plus au germe 9 un mouvement de rotation autour de son axe.

Comme dans le cas des figures 3 et 4, il est nécessaire de refondre une partie du solide précédemment formé lorsque, après une révolution complète, le solide repasse au-dessus de la filière 3. Avec ce mode de mise en oeuvre du procédé de l'invention, on obtient un hémisphère de rayon $a$ lorsque les dimensions $a$ et $b$ sont égales.

A titre d'exemple, on décrit ci-après la réalisation d'une demi-sphère monocristalline en saphir blanc (oxyde d'aluminium $Al_2O_3$). La température de fusion du saphir est de 2 050°C et l'on peut obtenir le bain liquide par chauffage inductif ou résistif de poudre d'alumine dans un creuset de molybdène. On utilise comme filière un simple tube de molybdène plongeant dans le bain liquide, ayant un conduit interne 5 de 1 mm de diamètre et un diamètre externe de 4 mm, ce qui permet d'obtenir une paroi d'épaisseur $e$ légèrement inférieure à 4 mm, cette épaisseur variant en fonction de la hauteur de l'interface par rapport à la filière. On réalise le tirage sous atmosphère d'argon ou sous vide.

Au début du tirage, on amène le germe monocristallin 9 au contact du liquide et on stabilise l'interface solide-liquide 11 à environ 1 mm au-dessus de la sortie de la filière 3. Pour obtenir une sphère de diamètre 10 mm, on fait varier la vitesse de tirage $v_t$ entre 0 et 30 mm/h suivant la formule donnée plus haut et la vitesse $v_h$ dans les mêmes proportions en respectant les formules données plus haut. La vitesse de rotation $\omega$ est variable de façon à obtenir une vitesse linéaire du cristal par rapport au liquide au niveau du ménisque 3 comprise dans la gamme de 2 à 20 mm/s pour optimiser la qualité du cristal. Le tirage d'une telle demi-sphère dure environ 4 heures.

On peut donc réaliser par le procédé de l'invention des pièces en saphir monocristallin de forme complexe, ce qui est intéressant, car ce matériau présente simultanément une très forte résistance à la corrosion, une dureté très élevée et une grande transparence.

On peut bien entendu utiliser le procédé de l'invention avec d'autres matériaux, en particulier des métaux, des oxydes, des alliages, des semi-conducteurs, des cristaux ioniques ou covalents et tout matériau présentant des propriétés optiques, électroniques, mécaniques ou de stabilité chimique intéressantes.

On peut ainsi fabriquer des creusets et vases pour la chimie résistant à la corrosion et aux hautes températures, et des manchons transparents de section variable en forme et en taille pour protéger des dispositifs en atmosphère corrosive.

Dans le cas du saphir, comme celui-ci est transparent dans une très grande gamme de longueur d'onde, on peut fabriquer des pièces optiques transparentes de forme variée pouvant par ailleurs résister à l'abrasion et à la corrosion, par exemple des hublots ou des lentilles.

Avec ce procédé, on peut également réaliser des cristaux détecteurs de rayonnement pour l'industrie nucléaire, médicale ou électronique, par exemple en germanate de bismuth (BGO) en niobate de lithium ($LiNbO_3$), en semi-conducteurs, par exemple CdTe, ainsi que des cristaux pour des pièces de structure pour l'industrie nucléaire.

## Revendications

1. Procédé de fabrication d'une pièce en matériau polycristallin ou monocristallin consistant à former la pièce à partir d'un bain dudit matériau fondu par tirage au travers d'une filière et cristallisation du matériau fondu sortant de la filière sur un germe, caractérisé en ce que, au cours du tirage, on soumet de plus la filière et/ou le germe à au moins un mouvement de translation dans un plan perpendiculaire à la direction de tirage.

2. Procédé selon la revendication 1, caractérisé en ce que l'on soumet de plus le germe à un mouvement de rotation autour d'un axe centré sur le germe.

3. Procédé selon la revendication 1 de fabrication d'une pièce en forme de plaque, caractérisé en ce que pendant toute la durée du tirage, on soumet la filière et/ou le germe à un mouvement de va et vient entre deux positions extrêmes, la distance entre ces deux positions déterminant la largeur de la plaque.

4. Procédé selon la revendication 1 de fabrication d'une cuve de section rectangulaire ou carrée à fond plat, caractérisé en ce qu'il comprend :
   - une première phase dans laquelle on forme les parois de la cuve en soumettant à des mouvements de translation dans une première direction puis dans une deuxième direction, le germe ou la filière, de façon à décrire la section droite de la pièce à obtenir, et
   - une deuxième phase dans laquelle on forme le fond de la cuve en soumettant la filière ou le germe à un mouvement de va et vient entre deux positions telles que la distance entre ces deux positions corrresponde à la longueur (ou à la largeur) de la section de la cuve, en déplaçant la filière ou le germe entre deux mouvements de va et vient dans un sens perpendiculaire au tracé du mouvement précédent d'une distance légèrement inférieure à la largeur de la filière, et en renouvelant ces opérations autant de fois qu'il est nécessaire pour couvrir le fond.

5. Procédé selon la revendication 2 de fabrication d'une pièce ayant la forme d'un ellipsoïde de révolution creux de demi-axes $\underline{a}$ et $\underline{b}$, caractérisé en ce que l'on soumet la filière à un mouvement de translation horizontale entre une première position dans laquelle le germe et la filière sont alignés et une deuxième position dans laquelle le germe est à la distance $\underline{b}$ de la filière, on soumet simultanément le germe à un mouvement de translation vertical et à un mouvement de rotation autour d'un axe vertical centré sur le germe, et on règle la vitesse $v_h$ de translation horizontale de la filière et la vitesse $v_t$ de tirage vertical du germe de façon telle que, à l'instant t,

$$v_t = (\pi a / 2 \tau) \sin (\pi t / 2 \tau)$$
$$v_n = (\pi b / 2 \tau) \cos (\pi t / 2 \tau)$$

avec $\tau$ représentant la durée du tirage.

6. Procédé selon l'une quelconque des revendications 1 à 5, caractérisé en ce que la filière est constituée par un tube de section circulaire ou carrée, munie d'au moins un perçage interne.

FIG. 1

FIG. 2

FIG. 3

FIG. 4

FIG. 5

FIG. 6

Office européen
des brevets

# RAPPORT DE RECHERCHE EUROPEENNE

Numero de la demande

EP 94 40 2562

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X,D | JOURNAL OF CRYSTAL GROWTH., vol.104, no.1, 1 Juillet 1990, AMSTERDAM NL pages 69 - 76 BORODIN ET AL 'local shaping technique and new growth apparatus for complex sapphire products' * le document en entier * | 1,2 | C30B15/34 C30B15/00 |
| X | JOURNAL OF CRYSTAL GROWTH., vol.82, no.1-2, 1 Mars 1987, AMSTERDAM NL pages 89 - 94 BORODIN ET AL 'variable shaping growth of refractory oxide shaped crystals' | 1,2 | |
| A | WO-A-92 01091 (SAPHIKON INC) | | |
| A | FR-A-2 159 339 (TYCO LABORATORIES INC) | | |

**DOMAINES TECHNIQUES RECHERCHES (Int.Cl.6)**

C30B

Le présent rapport a été établi pour toutes les revendications

| Lieu de la recherche | Date d'achèvement de la recherche | Examinateur |
|---|---|---|
| LA HAYE | 15 Février 1995 | Cook, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)